# EUROPÄISCHE PATENTSCHRIFT

(11) **EP 3 510 447 B1**
(45) Veröffentlichungstag und Bekanntmachung des Hinweises auf die Patenterteilung: **13.07.2022**
(21) Anmeldenummer: 17784552.6
(22) Anmeldetag: 07.09.2017
(51) Int. Cl.: G03F 7/20

(54) **LITHOGRAPHIEANLAGE MIT EINER VORRICHTUNG ZUR ÜBERTRAGUNG VON ELEKTRISCHEN SIGNALEN**
LITHOGRAPHIC APPARATUS WITH DEVICE FOR TRANSMITTING ELECTRICAL SIGNALS
APPAREIL LITHOGRAPHIQUE AVEC DISPOSITIF DE TRANSMISSION DE SIGNAUX ÉLECTRIQUES

(30) Priorität: 12.09.2016 DE 102016217285
(43) Veröffentlichungstag der Anmeldung: 17.07.2019
(73) Patentinhaber: Carl Zeiss SMT GmbH, 73447 Oberkochen (DE)
(72) Erfinder: HORN, Jan, 80636 München (DE); BLEIDISTEL, Sascha, 73432 Aalen (DE); BART, Florian, 73434 Aalen (DE); HAUF, Markus, 89075 Ulm (DE)
(74) Vertreter: Horn Kleimann Waitzhofer Patentanwälte PartG mbB
(86) Internationale Anmeldenummer: PCT/EP2017/072460
(87) Internationale Veröffentlichungsnummer: WO 2018/046597

(56) Entgegenhaltungen:
- EP-A2- 1 052 549
- JP-A- 2005 106 166
- US-A1- 2016 126 055

## Beschreibung

Die vorliegende Erfindung betrifft eine Lithographieanlage mit einer Vorrichtung zur Übertragung von elektrischen Signalen.

Lithographie wird zur Herstellung mikro- und nanostrukturierter Bauelemente, wie beispielsweise integrierter Schaltkreise, angewendet. Der Lithographieprozess wird mit einer Lithographieanlage durchgeführt, welche ein Beleuchtungssystem und ein Projektionssystem aufweist. Das Bild einer mittels des Beleuchtungssystems beleuchteten Maske (Retikel) wird hierbei mittels des Projektionssystems auf ein mit einer lichtempfindlichen Schicht (Photoresist) beschichtetes und in der Bildebene des Projektionssystems angeordnetes Substrat (z. B. ein Siliziumwafer) projiziert, um die Maskenstruktur auf die lichtempfindliche Beschichtung des Substrats zu übertragen.

Daher wird Projektions- oder Nutzlicht zum Abbilden einer lithografischen Struktur auf die Bild- oder Waferebene eingesetzt. Getrieben durch das Streben nach immer kleineren Strukturen bei der Herstellung integrierter Schaltungen werden derzeit EUV-Lithographieanlagen entwickelt, welche Projektions- oder Nutzlicht mit einer Wellenlänge im Bereich von 0,1 nm bis 30 nm, insbesondere 13,5 nm, verwenden. Bei solchen EUV-Lithographieanlagen müssen wegen der hohen Absorption der meisten Materialien von Licht dieser Wellenlänge reflektierende Optiken, das heißt Spiegel, anstelle von - wie bisher - brechenden Optiken, das heißt Linsen, eingesetzt werden.

Bei derartig kleinen Strukturen ist es wichtig, eine hohe Abbildungsgüte zu erreichen. Dies trifft insbesondere auch auf Prozesse mit mehrfachen Belichtungen zu. Aus diesem Grund müssen jegliche Fehlerquellen, die zu einer Verschlechterung der Abbildung beitragen, betrachtet und bestenfalls ausgeschaltet werden. Typische Abbildungsfehler können beispielsweise mit adaptiven Optiken minimiert werden. Starken Einfluss können insbesondere Vibrationen haben. Diese entstehen in allen Bereichen einer Lithographieanlage selbst, beispielsweise durch strömendes Kühlwasser oder Luftströmungen, als auch durch menschliche Aktivität in dem Gebäude oder durch Verkehr in der Umgebung. Vibrationen können dazu führen, dass optische Elemente selbst in Schwingung geraten, wobei sich beispielsweise deren Oberfläche deformieren kann, was die Eigenschaften des optischen Elements beeinträchtigt. Insbesondere bei Spiegeln wirken sich derartige Fehler doppelt aus, da ein Fehler im Einfallswinkel einen gleich großen Fehler im Ausfallswinkel induziert.

Es gibt verschiedene Maßnahmen, um sensitive Bauteile oder Baugruppen, beispielsweise die Projektionsoptik einer Lithographieanlage, mechanisch von der Umgebung zu entkoppeln. Allerdings ist es bei adaptiven Optiken nötig, sowohl Steuersignale für Bauteile, wie Aktoren oder Sensoren, zwischen der Optik und einer externen Steuerung sowie eine Versorgungsspannung zu den aktiven Bauteilen zu übertragen. Hierfür sind Signal- und Stromleitungen nötig. In Abhängigkeit von den Anforderungen der Lithographieanlage sind die Leitungskabel isoliert und/oder abgeschirmt. Insbesondere bei Signalleitungen besteht der Bedarf, die Leitungen von unerwünschten Einflüssen abzuschirmen, um eine fehlerfreie Signalübertragung zu gewährleisten. Dies wird beispielsweise durch einen mehrschichtigen Aufbau, wie bei mehrfach geschirmten Signalleitungen oder Koaxialkabeln, erreicht. Ein solcher mehrschichtiger Aufbau eines Kabels führt zu einer nicht unerheblichen Steifigkeit des Kabels. Ein solches steifes Kabel stellt daher auch eine mechanische Kopplung eines äußeren Rahmens mit der Projektionsoptik bzw. den verschiedenen aktiven Bauelementen her. Eine große Zahl an steuerbaren Bauelementen bedingt eine entsprechend große Zahl an Kabeln, was die mechanische Kopplung entsprechend verstärkt. Beispielsweise werden für eine Verbindung nach USB 1.0 Spezifikation vier Adern benötigt: Masse, +5V, Daten+, Daten-. Die USB 3.1 Spezifikation weist bereits 24 Adern aus, die beispielsweise in einem Kabel zusammengefasst sind. Je mehr Adern ein Kabel aufweist, umso steifer wird es. Dementsprechend erhöht sich auch eine mechanische Kopplungsstärke über das Kabel. Ebenso erhöht sich die mechanische Kopplung, wenn mehrere Kabel verwendet werden.

Eine Möglichkeit, um die Anzahl an Kabeln zu reduzieren, besteht in einer drahtlosen Kommunikation. Hierfür müssen allerdings alle mechatronischen Komponenten mit einem entsprechenden Empfänger ausgerüstet sein. Diese Art der Datenübertragung ist anfälliger für Störungen im Vergleich mit kabelgebundenen Systemen. Ferner ist die Datenübertragungsrate stärker begrenzt. Zuletzt ist auch bei diesen Systemen eine Stromversorgung nötig, so dass zumindest eine gewisse Anzahl an drahtgebundenen Übertragungen vorhanden sein muss. Bekannte kabelgebundene Systeme verwenden beispielsweise Kabelschleifen und längere Kabel als nötig, um eine Übertragung von Vibrationen über die Kabel zu reduzieren. Um eine geringe mechanische Kopplung zu realisieren, wird beispielsweise die Kabellänge in Abhängigkeit einer Kabelsteifigkeit gewählt. Diese Lösung hat jedoch einen entsprechend großen Platzbedarf und ist daher nicht immer einsetzbar. US 2016/126055 A1 sowie JP 2005 106166 A beschreiben bekannte Vorrichtungen, die eine elektrische Signalübertragung bei möglichst geringer Übertragung von Vibrationen zum Ziel haben.

Vor diesem Hintergrund besteht eine Aufgabe der vorliegenden Erfindung darin, eine Lithographieanlage mit einer verbesserten Vorrichtung zur Übertragung von elektrischen Signalen bereitzustellen.

Gemäß einem Aspekt wird eine Lithographieanlage mit einer Vorrichtung zur Übertragung von elektrischen Signalen zwischen einem ersten Schnittstellenelement und einem zweiten Schnittstellenelement vorgeschlagen. Das erste Schnittstellenelement ist an einer ersten Struktur der Lithographieanlage angeordnet und das zweite Schnittstellenelement ist an einer zweiten Struktur der Lithographieanlage angeordnet. Ein elektrischer Leiter verbindet die beiden Schnittstellenelemente miteinander. Ferner ist ein Hohlkörper zur elektromagnetischen Abschirmung des elektrischen Leiters vorgesehen, der den elektrischen Leiter zumindest abschnittsweise umgibt. Ein Spalt in dem Hohlkörper oder zwischen dem Hohlkörper und einer der Strukturen lässt dabei eine Relativbewegung der ersten Struktur und der zweiten Struktur zu, so dass eine mechanische Entkopplung der ersten Struktur und der zweiten Struktur erzielt ist.

Die vorgeschlagene Vorrichtung ermöglicht eine optimale Abschirmung des elektrischen Leiters von äußeren Störfeldern. Der Hohlkörper dient dabei als Schirm, mit dem Zweck, äußere elektrische, magnetische und/oder elektromagnetische Felder von seinem Innenraum fernzuhalten oder zu schwächen. Dies wird im Folgenden mit elektromagnetischer Abschirmung oder auch kurz mit Abschirmung bezeichnet. In dem abgeschirmten Innenraum des Hohlkörpers verlaufende elektrische Leiter können daher ohne eine individuelle Abschirmung oder nur mit einer einfachen Abschirmung ausgebildet sein. Dies ermöglicht es, eine Flexibilität des elektrischen Leiters zu verbessern.

Die durch den Hohlkörper bewirkte elektromagnetische Abschirmung des elektrischen Leiters hat verschiedene positive Effekte, wie im Folgenden verdeutlicht wird.

Elektrische Signale liegen beispielsweise als digitale Signale vor, die einen Datenstrom bilden können. Beispielsweise kann ein Sensor erfasste Sensordaten als ein Datenstrom an eine Auswertevorrichtung senden. Insbesondere bei der digitalen Datenübertragung ist eine fehlerfreie Übertragung erstrebenswert, da damit ein Nutzdatendurchsatz erhöht werden kann. Je weniger störanfällig eine digitale Signalverbindung ist, umso weniger Kontrolldatenpakete werden benötigt, um die übertragenen Nutzdaten zu verifizieren. Die gesamte übertragene Datenmenge setzt sich hierbei zumindest aus den Nutzdaten und den Kontrolldaten zusammen. Die Kontrolldatenpakete können als Overhead bezeichnet werden, da sie nicht zur eigentlichen Informationsübertragung beitragen. Da Sensorsysteme eine sehr große Datenmenge in kurzer Zeit erfassen können, sind entsprechend schnelle Datenverbindungen wünschenswert. Wenn beispielsweise der Overhead reduziert werden kann, so kann eine entsprechend höhere Nutzdatenmenge übertragen werden.

Beispielsweise kann auch ein Temperatursensor vorgesehen sein, dessen Widerstandswert in Abhängigkeit seiner Temperatur variiert. Hierbei ist das Sensorsignal ein analoges elektrisches Signal. Auch bei analogen Signalen können elektromagnetische Störfelder zu einer fehlerhaften Signalübertragung führen. Ferner können Bauteile, die an einen elektrischen Leiter angeschlossen sind, sehr empfindlich gegenüber auftretenden Spannungs- und/oder Stromschwankungen sein. Derartige Schwankungen können durch äußere Störfelder induziert werden und können bis zur Zerstörung eines Bauteils führen. Beispielsweise kann eine Aktuierungsstärke eines mechanischen Aktuators von einer Versorgungsspannung abhängen. Wenn Störfelder Spannungsschwankungen der Versorgungsspannung verursachen, kann dies somit zu einer fehlerhaften Aktuierung durch den Aktuator führen.

Unter elektromagnetischen Störfeldern werden vorliegend alle denkbaren Arten einer Beeinflussung eines elektrischen Signals umfasst. Damit sind beispielsweise auch statische oder nur sehr langsam variierende elektrische oder magnetische Felder gemeint.

Eine Lithographieanlage umfasst mehrere Strukturen, wie beispielsweise eine Lichtquelle, eine Strahlformungsoptik, eine Lithographiemaske, eine Projektionsoptik, einen Waferschlitten, sowie verschiedene weitere funktionelle und/oder Stabilität vermittelnde Strukturen. Insbesondere bei der Belichtung von Wafern ist es wichtig, dass während einer Belichtungszeit, die beispielsweise einen Bruchteil einer Sekunde bis hin zu mehrere Sekunden umfassen kann, Relativbewegungen insbesondere eines zu belichtenden Wafers zu einem erzeugten Abbild der Lithographiemaske vermieden werden. Auch ungewollte Verschiebungen von einzelnen optischen Komponenten, die die Abbildung der Lithographiemaske durch das Projektionsobjektiv beeinflussen können, sind zu vermeiden. Eine Amplitude einer Relativbewegung sollte dabei eine vorgesehene Maximalgrenze nicht überschreiten. Diese kann im Bereich von Nanometern liegen. Um dies sicherzustellen sind beispielsweise Erschütterungen, Schwingungen, Stöße, Vibrationen und dergleichen von der Lithographieanlage oder von den Strukturen der Lithographieanlage fernzuhalten. Dabei ist zu beachten, dass beispielsweise auch elektrische Leiter und Kabel eine mechanische Kopplung erzeugen. Um diese mechanische Kopplung zu minimieren, kann mit der vorgeschlagenen Vorrichtung beispielsweise auf eine individuelle Kabelabschirmung verzichtet werden. Vorteilhaft können somit flexible elektrische Leiter zur Verbindung der beiden Schnittstellenelemente verwendet werden.

Ein Schnittstellenelement kann beispielsweise als ein Stecker oder eine Buchse ausgebildet sein. Das Schnittstellenelement kann auch durch einzelne Pins oder Kontaktpunkte realisiert sein. Vorteilhafterweise weisen das erste und das zweite Schnittstellenelement eine gleich große Anzahl an Kontakten auf. Für jeden Kontakt ist dann ein elektrischer Leiter benötigt, der mit dem korrespondierenden Kontakt des weiteren Schnittstellenelements verbunden wird. Eine Verbindung kann beispielsweise durch Steckverbinder hergestellt werden. Auch kleben, löten, pressen, schweißen und/oder ähnliche Verfahren können zur Verbindung des elektrischen Leiters mit einem Schnittstellenelement verwendet werden. Das Schnittstellenelement kann im Folgenden auch verkürzt einfach als Schnittstelle bezeichnet werden.

Der Hohlkörper weist eine Hülle auf. Die Hülle ist insbesondere aus einem Material gefertigt, das eine gute Abschirmeigenschaft für die relevanten Störfelder aufweist. Beispielsweise kann das Material für eine Abschirmung elektrischer Felder elektrisch gut leitend sein. Zur Abschirmung magnetischer Felder, insbesondere niederfrequenter magnetischer Felder, kann das Material beispielsweise ferromagnetisch sein. Der Innenraum des Hohlkörpers ist dann ein von elektromagnetischen Störfeldern abgeschirmtes Volumen. Ein elektrischer Leiter, der durch diesen Innenraum verläuft, ist daher zumindest in dem Bereich des Innenraums abgeschirmt. Im Folgenden kann mit Hohlkörper sowohl das gesamte von dem Hohlkörper umfasste Volumen als auch lediglich die Hülle des Hohlkörpers bezeichnet werden.

Der Hohlkörper kann beispielsweise aus einem starren, selbsttragenden Material gefertigt sein. Der Hohlkörper kann auch unterschiedliche Materialien umfassen. Beispielsweise kann der Hohlkörper eine Stützstruktur aufweisen, die mit einem metallischen Netz belegt ist. Eine solche Ausführungsform des Hohlkörpers kann Gewichtsvorteile mit sich bringen und flexibler einsetzbar sein.

Der Hohlkörper weist beispielsweise einen Spalt auf. Der Spalt ist dabei so angelegt, dass elektromagnetische Störfelder durch diesen nicht oder zumindest nicht wesentlich in das Innere des Hohlkörpers eindringen können. Dies kann durch eine entsprechende Dimensionierung des Spalts erreicht werden. Dabei ist es vorteilhaft, den Spalt nicht größer als benötigt zu machen.

Der Hohlkörper kann aber auch so ausgebildet sein, dass er mit einer der beiden Strukturen einen Spalt ausbildet.

Aufgrund des Spalts ist eine Relativbewegung zwischen den beiden Strukturen möglich. Es geht dabei weniger um eine beabsichtigte Verschiebung der beiden Strukturen zueinander, obwohl auch dies eine mögliche Anwendung der Vorrichtung ist. Insbesondere werden von dem Hohlkörper keine Schwingungen, Vibrationen, Stöße oder weitere mechanische Impulse von der ersten Struktur auf die zweite Struktur übertragen. Aufgrund des abgeschirmten Innenraums des Hohlkörpers können in dem Innenraum des Hohlkörpers verlaufende elektrische Leiter und/oder Kabel einfacher aufgebaut werden, insbesondere können Maßnahmen zur Abschirmung reduziert werden. Dies wiederum hat zu Folge, dass eine mechanische Kopplung der Schnittstellenelemente über den elektrischen Leiter und/oder das Kabel reduziert werden kann. Insgesamt eignet sich die vorgeschlagene Vorrichtung somit zu einer kabelgebundenen elektrischen Signalübertragung zwischen zwei Schnittstellenelementen bei minimierter mechanischer Kopplung.

Gemäß einer ersten Ausführungsform ist die Vorrichtung in einem Vakuumgehäuse angeordnet. Das Vakuumgehäuse kann auch als evakuiertes Gehäuse bezeichnet werden.

Lithographieanlagen können evakuierte Gehäuse aufweisen, da dies für die verwendete UV-Strahlung vorteilhaft sein kann. Insbesondere bei EUV-Lithographieanlagen wird das Projektionslicht vorzugsweise durch Vakuum geführt, da bereits typische Gase eine unerwünschte Absorption der EUV-Strahlung aufweisen. Beispielsweise kann das Projektionsobjektiv insgesamt evakuiert sein. Dann stellt das Gehäuse des Projektionsobjektivs ein Vakuumgehäuse dar. Das erste Schnittstellenelement kann beispielsweise auf einer Innenseite des Projektionsobjektivs angeordnet sein und das zweite Schnittstellenelement kann beispielsweise an einer mechanisch von dem Projektionsobjektiv entkoppelten Linsen- oder Spiegelhalterung angeordnet sein.

Gemäß einer weiteren Ausführungsform der Vorrichtung ist der elektrische Leiter zumindest abschnittsweise als eine flexible Leiterplatte ausgebildet.

Eine flexible Leiterplatte weist beispielsweise ein flexibles Substrat auf. Das Substrat kann zum Beispiel aus Polyamid und/oder Polyimid bestehen. Auf dieses Substrat ist beispielsweise eine Leiterbahn aufgebracht. Die Leiterbahn kann zum Beispiel aus Kupfer bestehen. Die Leiterbahn kann dabei beispielsweise auf das Substrat geklebt oder mit diesem verschweißt sein. Da eine strukturelle Integrität und mechanische Stabilität von dem flexiblen Substrat geleistet wird, kann die Leiterbahn einen sehr kleinen Querschnitt aufweisen. Beispielsweise kann eine Leiterbahn einen rechteckigen Querschnitt mit einer Höhe von wenigen Mikrometern aufweisen. Aufgrund der geringen Höhe lässt diese Leiterbahn eine variable Krümmung um eine Achse entlang einer Breite der Leiterbahn zu. Insgesamt weist die flexible Leiterplatte daher eine hohe Flexibilität auf, was zu einer reduzierten mechanischen Kopplungsstärke beiträgt.

Eine flexible Leiterplatte kann auch einen mehrschichtigen Aufbau aufweisen. Dabei kann jede Schicht Leiterbahnen aufnehmen. Bevorzugt ist zwischen jeweils zwei Schichten mit einer Leiterbahn eine isolierende Schicht eingefügt. In einer Schicht können auch mehrere Leiterbahnen nebeneinander angeordnet sein.

Diese Ausführungsform ist besonders vorteilhaft, wenn wenig Platz für eine Verkabelung gegeben ist.

Gemäß einer weiteren Ausführungsform der Vorrichtung ist der Hohlkörper an der ersten Struktur angeordnet und leitend mit dieser verbunden. Ferner weist der Hohlkörper eine der zweiten Struktur zugewandte Öffnung auf. Die Öffnung wird von einem Rand des Hohlkörpers begrenzt, welcher mit der zweiten Struktur den Spalt ausbildet.

In dieser Ausführungsform ist der Hohlkörper somit ein einstückiger Körper. Der Rand des Hohlkörpers kann dabei eine vorgegebene Form aufweisen, beispielsweise kann der Rand durch eine umlaufende Fläche gebildet werden, die jeweils abschnittsweise entsprechend einer Krümmung der zweiten Struktur gekrümmt ist. Der Rand kann aber auch nur durch einen Querschnitt der Hülle des Hohlkörpers gebildet sein. Zwischen dem Rand und der zweiten Struktur bildet sich hierbei der Spalt aus, welcher eine Relativbewegung des Hohlkörpers zu der zweiten Struktur und damit auch eine Relativbewegung der ersten Struktur zu der zweiten Struktur zulässt.

Aufgrund der leitenden Verbindung des Hohlkörpers mit der ersten Struktur ist das Potential des Hohlkörpers gleich dem Potential der ersten Struktur. Vorteilhaft weist auch die zweite Struktur dieses Potential auf, beispielsweise ein Massepotential.

Gemäß einer weiteren Ausführungsform der Vorrichtung umfasst der Hohlkörper zwei Teilkörper. Ein erster Teilkörper ist an der ersten Struktur angeordnet und leitend mit dieser verbunden. Ein zweiter Teilkörper ist an der zweiten Struktur angeordnet und leitend mit dieser verbunden. Der Spalt ist in einem Überdeckungsabschnitt zwischen den beiden Teilkörpern in dem Hohlkörper ausgebildet.

Die beiden Teilkörper des Hohlkörpers können gleich, aber auch unterschiedlich ausgebildet sein. Beispielsweise ist vorstellbar, dass der erste Teilkörper aus einem massiven Metall gebildet ist und der zweite Teilkörper eine mehrteilige Hülle aufweist. Beispielsweise kann der zweite Teilkörper aus einer tragenden Skelettstruktur und einer abschirmenden, auf der Skelettstruktur aufliegenden Netzstruktur gebildet sein. Die Teilkörper sind leitend mit der jeweiligen Struktur verbunden, wodurch sie das jeweilige Potential der Struktur aufweisen. Vorteilhaft ist das Potential der ersten Struktur und das Potential der zweiten Struktur das gleiche Potential, beispielsweise ein Massepotential. Die Teilkörper können auch unterschiedliche Potentiale aufweisen.

Die beiden Teilkörper weisen insbesondere einen Überdeckungsabschnitt auf. Hierfür sind die Teilkörper in dem Überdeckungsabschnitt so geformt, dass sie eine geometrisch ähnliche Form aufweisen. Beispielsweise sind die beiden Teilkörper als Rohre mit einem kreisförmigen Querschnitt ausgebildet. Vorteilhaft ist in dem Überdeckungsabschnitt der Außenradius des einen Teilkörpers kleiner als der Innenradius des anderen Teilkörpers. Dann können die Teilkörper ein Stück weit ineinander geschoben werden, was einen vergrößerten Überdeckungsabschnitt mit sich bringt, der verbesserte Abschirmeigenschaften gegenüber einem Spalt mit kleinerem Überdeckungsabschnitt aufweist. Es ist aber auch möglich, dass die beiden Teilkörper eine gleiche Form und gleiche Größe aufweisen und der Spalt zwischen den stoßseitigen Querschnitten der Hüllen gebildet wird.

Gemäß einer weiteren Ausführungsform der Vorrichtung ist in dem ersten Teilkörper eine erste Leiterplatte vorgesehen, die mit dem ersten Schnittstellenelement elektrisch verbunden ist. In dem zweiten Teilkörper ist eine zweite Leiterplatte vorgesehen, die mit dem zweiten Schnittstellenelement elektrisch verbunden ist. Ferner ist die erste Leiterplatte mit der zweiten Leiterplatte über den elektrischen Leiter verbunden.

Die erste Leiterplatte und die zweite Leiterplatte sind hierbei insbesondere als starre Leiterplatten ausgebildet. Die Leiterplatte ist jeweils mit dem Schnittstellenelement verbunden. Eine Verbindung der Leiterplatte mit dem jeweiligen Schnittstellenelement kann dabei mittels starrer Drähte, Kabel oder Leitungen erfolgen, da eine mechanische Entkopplung bei dieser Verbindung nicht maßgeblich ist. Dabei kann die Leiterplatte dazu eingerichtet sein, die von dem jeweiligen Schnittstellenelement bereitgestellten Kontakte zu reproduzieren. Alternativ kann es aber auch vorgesehen sein, auf der Leiterplatte bereits elektronische Bauteile wie Signalverstärker, Spannungswandler, Schalter, Transistoren, Dioden und/oder weitere Bauelement dieser Art anzuordnen. Da die Leiterplatten in dem abgeschirmten Innenraum des Hohlkörpers angeordnet sind, sind diese Bauteile automatisch von äußeren Störfeldern abgeschirmt.

Diese Ausführungsform kann auch vorteilhaft sein, wenn eine größere Strecke zwischen den zu verbindenden Schnittstellenelementen liegt. Dann kann ein Großteil der Strecke mit herkömmliche Leitern oder Kabeln verbunden werden, und lediglich eine kürzere Strecke zwischen den beiden Leiterplatten, insbesondere der Abschnitt über den Spalt, kann mit einem flexiblen Leiter ausgebildet sein. Flexible Leiter sind meist teurer als herkömmliche Leiter, weshalb dies zu einer Kostenreduzierung beitragen kann.

Gemäß einer weiteren Ausführungsform der Vorrichtung ist die erste Leiterplatte mit der zweiten Leiterplatte über die flexible Leiterplatte verbunden.

Gemäß einer weiteren Ausführungsform der Vorrichtung weist die flexible Leiterplatte einen ersten Randabschnitt und einen dem ersten Randabschnitt gegenüberliegenden zweiten Randabschnitt auf, wobei die flexible Leiterplatte entlang ihres Verlaufs derart verdreht ist, dass sie einen Abschnitt aufweist, in dem der erste Randabschnitt und der zweite Randabschnitt eine Helixform bilden.

Gemäß einer weiteren Ausführungsform der Vorrichtung weist die flexible Leiterplatte zumindest einen bestimmten Abschnitt auf, der gebogen und/oder verdreht ist.

Unter gebogen wird vorliegend verstanden, dass die Längsachse dieses bestimmten Abschnitts der flexiblen Leiterplatte keine Strecke ist, sondern beispielsweise ein Bogen.

Unter verdreht wird vorliegend verstanden, dass die Normalenvektoren auf die flexible Leiterplatte in diesem bestimmten Abschnitt der flexiblen Leiterplatte unterschiedliche Richtungen haben und eine jede Gruppe von drei der Normalenvektoren zueinander linear unabhängig sind. Die letztere Eigenschaft kann auch wie folgt beschrieben werden: Eine jede Gruppe von drei der Normalenvektoren spannen stets einen dreidimensionalen Raum auf. Dies gilt insbesondere für die Normalenvektoren auf die Längsachse des bestimmten Abschnitts der flexiblen Leiterplatte.

Eine flexible Leiterplatte ist beispielsweise als eine flache Bandstruktur mit einem Querschnitt mit einer großen Breite und einer kleinen Höhe senkrecht zu einer Länge der flexiblen Leiterplatte ausgebildet. Die Orientierung der Bandstruktur im Raum kann beispielsweise mittels eines Breitevektors, eines Höhenvektors und eines Längenvektors beschrieben werden. Eine solche Bandstruktur besitzt eine Flexibilität in einer Richtung senkrecht zu dem Breitevektor, beispielsweise eine x-Richtung. Die Flexibilität in einer Richtung entlang des Breitevektors, beispielsweise einer y-Richtung, wenn x-y ein kartesisches Koordinatensystem aufspannen, ist deutlich schlechter, wobei dies beispielsweise von einem Aspektverhältnis Breite/Höhe abhängt. Indem die Bandstruktur beispielsweise entlang einer Länge der flexiblen Leiterplatte um 90° gedreht wird, weist die flexible Leiterplatte in Abschnitten somit eine Flexibilität in x-Richtung auf und in weiteren Abschnitten eine Flexibilität in y-Richtung. Insgesamt ist somit eine zweidimensionale Flexibilität erreicht.

Die flexible Leiterplatte kann dabei in dem Abschnitt um beliebige Drehgrade verdreht sein. Vorteilhaft ist sie zumindest um 90° verdreht. Aber auch 180°, 270°, 360° oder weitere Drehgrade sind möglich.

Gemäß einer weiteren Ausführungsform ist die Vorrichtung in einer Niederdruck-Atmosphäre mit erhöhtem Wasserstoffgehalt angeordnet. Dann ist der Spalt derart eingerichtet, dass ein Eindringen von Wasserstoff in den Hohlkörper reduziert oder unterdrückt wird. Unter einem Eindringen kann beispielsweise auch eine Diffusion verstanden werden.

Insbesondere bei EUV-Lithographieanlagen können sich auf den reflektierenden Elementen Kontaminationen ablagern, die die optischen Eigenschaften verschlechtern. Eine Möglichkeit, die optischen Elemente zu reinigen ist es, diese mit Wasserstoff zu bestrahlen, wobei zumindest ein Anteil des Wasserstoffs als atomarer Wasserstoff, d.h. dissoziiert vorliegt. Der atomare Wasserstoff reagiert mit den meisten Kontaminationen unter Bildung flüchtiger Stoffe. Jedoch reichert sich durch diese Reinigungsmethode auch atomarer Wasserstoff in dem evakuierten Gehäuse an. Aufgrund der Reaktivität des atomaren Wasserstoffs ist es vorteilhaft, wenn empfindliche Strukturen, insbesondere organische Materialien wie Kabelisolierungen, Epoxidharze, Klebeverbindungen und flexible Leiterplatten, vor dem atomaren Wasserstoff geschützt werden.

In dieser Ausführungsform ist der Spalt dazu eingerichtet, das Eindringen von atomarem Wasserstoff einzuschränken. Damit ist sichergestellt, dass die verschiedenen in dem Hohlkörper angeordneten Teile oder Elemente, insbesondere Kabel, Leitungsisolierungen, Leiterplatten, Schnittstellen und dergleichen, vor dem atomaren Wasserstoff geschützt sind.

Gemäß einer weiteren Ausführungsform der Vorrichtung herrscht auf einer ersten Seite der ersten Struktur ein erster Druck und auf einer zweiten Seite der ersten Struktur herrscht ein gegenüber dem ersten Druck erhöhter, zweiter Druck. Das erste Schnittstellenelement ist auf einer Leiterplatte auf der ersten Seite ausgebildet, wobei die Leiterplatte ein weiteres Schnittstellenelement auf der zweiten Seite aufweist.

In dieser Ausführungsform dient die Leiterplatte vorteilhaft zugleich als eine Vakuumdurchführung, was den konstruktiven Aufwand reduzieren und Kosten senken kann.

Gemäß einer weiteren Ausführungsform der Vorrichtung sind das erste Schnittstellenelement und/oder das zweite Schnittstellenelement als eine Leiterplatte ausgebildet. Dies hat den Vorteil, dass eine Verdrahtung des Schnittstellenelements zu einer Leiterplatte entfallen kann.

Gemäß einer weiteren Ausführungsform der Vorrichtung ist der Spalt derart ausgebildet, dass er eine Relativbewegung zwischen der ersten Struktur und der zweiten Struktur von höchstens 200 µm, bevorzugt von höchstens 100 µm, weiter bevorzugt von höchstens 10 µm, zulässt.

Die benötigte Spaltgröße hängt insbesondere von der Vorgabe der mechanischen Entkopplung und den auftretenden Bewegungsamplituden ab. Unterschiedliche Strukturen, beispielsweise ineinander liegende Strukturen können mehrfach von weiteren Strukturen mechanisch entkoppelt sein. Beispielsweise kann das Gehäuse der Projektionsoptik von einem die Lithographieanlage umfassenden Gehäuse entkoppelt sein. Ferner können die optischen Elemente der Projektionsoptik selbst von dem Gehäuse der Projektionsoptik entkoppelt sein. Weiterhin kann ein Sensor, beispielsweise zur Erfassung einer Auslenkung eines Spiegels, nochmals entkoppelt angeordnet sein. Mit jeder Entkopplungsstufe steigt beispielsweise dabei die Anforderung an die Entkopplung, wobei gleichzeitig die erlaubten und damit zu erwartenden Bewegungsamplituden der zu entkoppelnden Strukturen sinken.

Ein schmalerer Spalt ist dabei für eine Abschirmung vorteilhaft, da durch den Spalt möglicherweise elektromagnetische Störfelder weniger stark eindringen können.

Gemäß einer weiteren Ausführungsform der Vorrichtung weist der elektrische Leiter eine mechanische Kopplungsstärke von höchstens 200 N/m, bevorzugt höchstens 100 N/m, weiter bevorzugt höchstens 20 N/m und noch weiter bevorzugt höchstens 7 N/m, auf.

Je geringer die mechanische Kopplungsstärke ist, umso weniger Vibrationen oder Schwingungen werden von dem elektrischen Leiter übertragen.

Gemäß einer weiteren Ausführungsform der Vorrichtung ist der elektrische Leiter als Teil eines das erste Schnittstellenelement und das zweite Schnittstellenelement verbindendes Kabel ausgebildet. Das Kabel weist eine Anzahl von einfach abgeschirmten Aderpaaren und/oder eine Anzahl von Spannungsversorgungsleitungen in einem Kabelmantel auf.

Mehrere elektrische Leiter können zu einem Kabel zusammengefasst werden. Beispielsweise weist ein Kabel fünf Aderpaare auf, von denen jedes zur Signalübertragung eingerichtet ist. Die Aderpaare sind vorteilhaft verdrillt, da sich damit Störeinflüsse auf beide Adern gleich auswirken. Bei differenzieller Signalübertragung mittelt sich ein Störeinfluss damit weitgehend heraus. Die Aderpaare sind beispielsweise jeweils abgeschirmt, um sich nicht gegenseitig zu beeinflussen. Die fünf verdrillten und einfach geschirmten Aderpaare sind in einem Kabel zusammengefasst. Da das Kabel in dem Hohlkörper verläuft, kann auf eine äußere Abschirmung des Kabels verzichtet werden. Dies ist für die Flexibilität des Kabels von entscheidendem Vorteil, da eine Kabelabschirmung, beispielsweise mit einem flexiblen Drahtnetz, einen großen Teil der Steifigkeit eines derart abgeschirmten Kabels bedingt.

Gemäß einer weiteren Ausführungsform der Vorrichtung weist die flexible Leiterplatte mehrere Leiterbahnen in mehreren Schichten auf, wobei in zumindest jeder zweiten Schicht zumindest eine Leiterbahn verläuft.

Indem die Abmessung von einzelnen Leiterbahnen als auch eine Anordnung der einzelnen Leiterbahnen entsprechend gewählt wird, können auch mit einer flexiblen Leiterplatte zumindest einfach geschirmte Leiterbahnpaare realisiert werden. Beispielsweise sind zwei Leiterbahnen auf einer mittleren Schicht nebeneinander angeordnet. Jeweils außen neben diesen Leiterbahnen auf der mittleren Schicht sind zwei weitere Leiterbahnen vorgesehen, die auf ein Massepotential gesetzt werden. Ferner ist in einer oberen Schicht und in einer unteren Schicht jeweils eine Leiterbahn vorgesehen, deren Breite so gewählt ist, dass sie die vier auf der mittleren Schicht angeordneten Leiterbahnen überdecken. Die Leiterbahn der oberen Schicht und der unteren Schicht werden ebenfalls auf ein Massepotential gesetzt. Mit einer solchen Anordnung ist eine einfache Abschirmung der beiden erstgenannten Leiterbahnen, die innere Leiterbahnen darstellen beispielsweise zur differenziellen Signalübertragung, ermöglicht. Neben dieser beispielhaften Ausführung sind verschiedene weitere Anordnungen denkbar, die zu einer verbesserten Abschirmung beitragen können.

Gemäß einer weiteren Ausführungsform der Vorrichtung ist der Spalt durch eine in dem Bereich des Überdeckungsabschnitts erste Randstruktur des ersten Teilkörpers und eine zu der ersten Randstruktur korrespondierende zweite Randstruktur des zweiten Teilkörpers ausgebildet. Dabei sind die erste Randstruktur und die zweite Randstruktur ineinandergreifende Strukturen.

Somit bilden die erste Randstruktur und die zweite Randstruktur ein Stück und ein Gegenstück. In dieser Ausführungsform kann ein Eindringen von elektromagnetischen Störfeldern in den Innenraum effizient unterdrückt werden. Ferner kann hiermit auch ein Eindringen, insbesondere eine Wasserstoffdiffusion, gehemmt werden.

Gemäß einer weiteren Ausführungsform der Vorrichtung ist der Hohlkörper an der ersten Struktur angeordnet und leitend mit dieser verbunden. Ferner ist er als ein einstückiger Hohlkörper ausgebildet, der eine der zweiten Struktur zugewandten Öffnung aufweist. Der Rand des Hohlkörpers zu der Öffnung bildet mit der zweiten Struktur den Spalt. Die zweite Struktur weist dabei insbesondere eine Randstruktur auf, die zu dem Rand des Hohlkörpers korrespondierend ist. Die Randstruktur der zweiten Struktur gehört dabei nicht zu dem Hohlkörper. Die Randstruktur ermöglicht es insbesondere, auch bei einem einstückig ausgebildeten Hohlkörper eine verbesserte Abschirmung von elektromagnetischen Störfeldern in dem Bereich des Rands sowie ein reduziertes Eindringen von Gasatomen zu erreichen.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.
Fig. 1a zeigt eine schematische Ansicht einer EUV-Lithographieanlage;
Fig. 1b zeigt eine schematische Ansicht einer DUV-Lithographieanlage;
Fig. 2 zeigt einen Querschnitt eines ersten Ausführungsbeispiels der Vorrichtung zur Übertragung von elektrischen Signalen;
Fig. 3 zeigt einen Querschnitt eines zweiten Ausführungsbeispiels der Vorrichtung zur Übertragung von elektrischen Signalen;
Fig. 4 zeigt einen Querschnitt eines dritten Ausführungsbeispiels der Vorrichtung zur Übertragung von elektrischen Signalen;
Fig. 5 zeigt einen Querschnitt eines vierten Ausführungsbeispiels der Vorrichtung zur Übertragung von elektrischen Signalen;
Fig. 6 zeigt einen Querschnitt eines fünften Ausführungsbeispiels der Vorrichtung zur Übertragung von elektrischen Signalen;
Fig. 7 zeigt einen Querschnitt eines Ausführungsbeispiels einer flexiblen Leiterplatte;
Fig. 8a zeigt schematisch einen Ausschnitt einer in einem Abschnitt zu einer Helixform verdrehten flexiblen Leiterplatte;
Fig. 8b zeigt eine schematische Ansicht einer Ausführungsform eines bestimmten Abschnitts einer flexiblen Leiterplatte;
Fig. 8c zeigt eine schematische Ansicht einer weiteren Ausführungsform eines bestimmten Abschnitts einer flexiblen Leiterplatte;
Fig. 9 zeigt schematisch ein Ausführungsbeispiel einer Leiterplatte als eine Vakuumdurchführung; und
Fig. 10a - Fig. 10c zeigen verschiedene Ausführungsbeispiele von Randstrukturen zur Ausbildung eines Spalts.

In den Figuren sind gleiche oder funktionsgleiche Elemente mit denselben Bezugszeichen versehen worden, sofern nichts anderes angegeben ist.

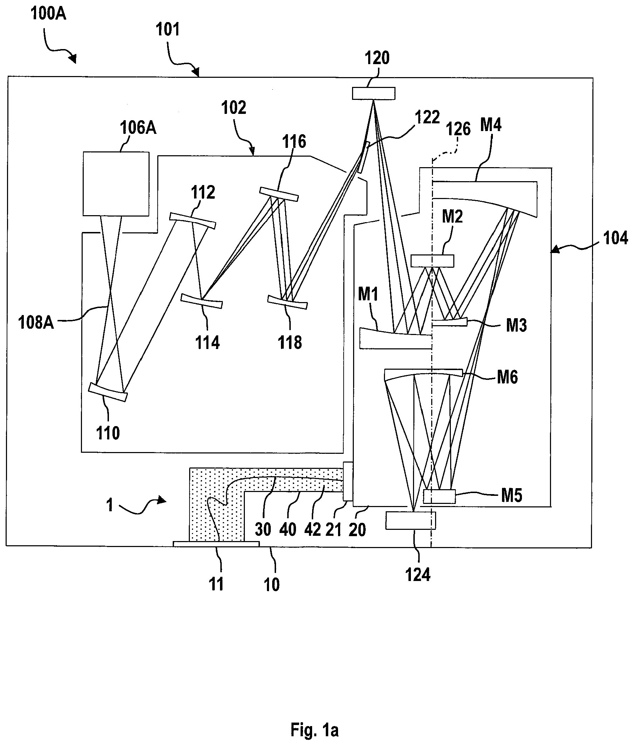

Fig. 1a zeigt eine schematische Ansicht einer EUV-Lithographieanlage 100A, welche ein Strahlformungs- und Beleuchtungssystem 102 und ein Projektionssystem 104 umfasst. Dabei steht EUV für "extremes Ultraviolett" (Engl.: extreme ultraviolet, EUV) und bezeichnet eine Wellenlänge des Arbeitslichts (auch Nutzstrahlung genannt) zwischen 0,1 und 30 nm. Das Strahlformungs- und Beleuchtungssystem 102 und das Projektionssystem 104 sind in einem Vakuumgehäuse 101 angeordnet. Das Vakuumgehäuse 101 wird mit Hilfe einer nicht dargestellten Evakuierungsvorrichtung evakuiert. Das Vakuumgehäuse 101 ist von einem nicht dargestellten Maschinenraum umgeben, in welchem beispielsweise Steuerungen zum Einstellen der optischen Elemente vorgesehen sind.

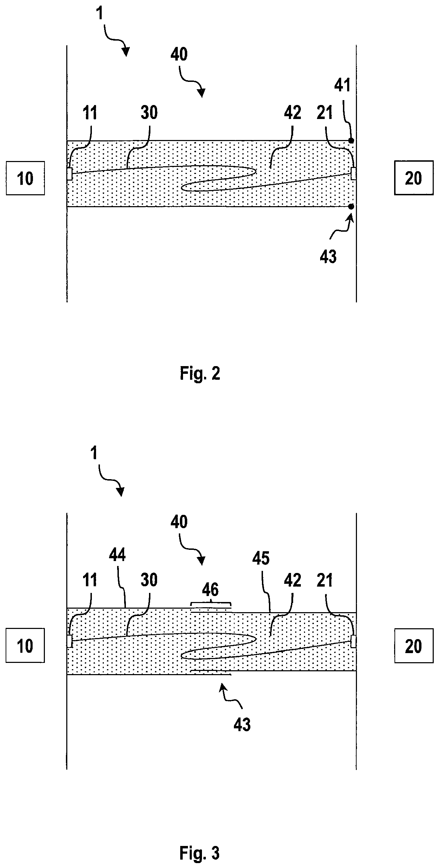

Zum Übertragen der elektrischen Signale weist die Lithographieanlage 100A eine Vorrichtung 1 auf. Die Vorrichtung 1 umfasst eine erste Schnittstelle 11, welche an einer ersten Struktur 10, die vorliegend ein Gehäuseteil des Vakuumgehäuses 101 darstellt, angeordnet ist. Weiterhin umfasst die Vorrichtung 1 eine an einer zweiten Struktur 20 angeordnete zweite Schnittstelle 21. Die zweite Struktur 20 ist vorliegend ein Teil des Gehäuses des Projektionssystems 104. Ferner umfasst die Vorrichtung 1 einen Hohlkörper 40 und einen in dem Hohlkörper 40 verlaufenden elektrischen Leiter 30, welche die erste Schnittstelle 10 mit der zweiten Schnittstelle 20 verbindet. Insbesondere ist der Hohlkörper 40 so beschaffen, dass sein Innenraum ein im Wesentlichen von elektromagnetischen Störfeldern freies Volumen 42 darstellt. Verschiedene Ausführungsbeispiele der Vorrichtung 1 sind in den Fig. 2 - Fig. 6 gezeigt.

Die EUV-Lithographieanlage 100A weist eine EUV-Lichtquelle 106A auf. Als EUV-Lichtquelle 106A kann beispielsweise eine Plasmaquelle (oder ein Synchrotron) vorgesehen sein, welche Strahlung 108A im EUV-Bereich (extrem ultravioletter Bereich), also z.B. im Wellenlängenbereich von 0,1 nm bis 30 nm, aussendet. Im Strahlformungs- und Beleuchtungssystem 102 wird die EUV-Strahlung 108A gebündelt und die gewünschte Betriebswellenlänge aus der EUV-Strahlung 108A herausgefiltert. Die von der EUV-Lichtquelle 106A erzeugte EUV-Strahlung 108A weist eine relativ niedrige Transmissivität durch Luft auf, weshalb die Strahlführungsräume im Strahlungs- und Beleuchtungssystem 102 und im Projektionssystem 104 evakuiert sind.

Das in Fig. 1a dargestellte Strahlformungs- und Beleuchtungssystem 102 weist fünf Spiegel 110, 112, 114, 116, 118 auf. Nach dem Durchgang durch das Strahlformungs- und Beleuchtungssystem 102 wird die EUV-Strahlung 108A auf die Photomaske (Engl.: reticle) 120 geleitet. Die Photomaske 120 ist beispielsweise als reflektives optisches Element ausgebildet und kann außerhalb der Systeme 102, 104 angeordnet sein. Weiter kann die EUV-Strahlung 108A mittels eines Spiegels 122 auf die Photomaske 120 gelenkt werden. Die Photomaske 120 weist Strukturen auf, welche mittels des Projektionssystems 104 verkleinert auf einen Wafer 124 oder dergleichen abgebildet werden. Dabei ist der Wafer 124 in der Bildebene des Projektionssystems 104 angeordnet.

Das Projektionssystem 104 (auch als Projektionsobjektiv bezeichnet) weist sechs Spiegel M1 - M6 zur Abbildung der Photomaske 120 auf den Wafer 124 auf. Dabei können einzelne Spiegel M1 - M6 des Projektionssystems 104 symmetrisch zur optischen Achse 126 des Projektionssystems 104 angeordnet sein. Es sollte beachtet werden, dass die Anzahl der Spiegel der EUV-Lithographieanlage 100A nicht auf die dargestellte Anzahl beschränkt ist. Es können auch mehr oder weniger Spiegel vorgesehen sein. Des Weiteren sind die Spiegel i.d.R. an ihrer Vorderseite zur Strahlformung gekrümmt.

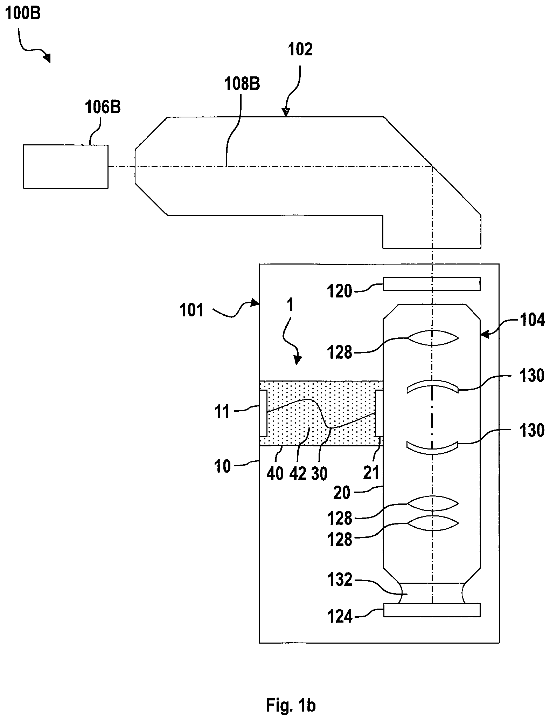

Fig. 1b zeigt eine schematische Ansicht einer DUV-Lithographieanlage 100B, welche ein Strahlformungs- und Beleuchtungssystem 102 und ein Projektionssystem 104 umfasst. Dabei steht DUV für "tiefes Ultraviolett" (Engl.: deep ultraviolet, DUV) und bezeichnet eine Wellenlänge des Arbeitslichts (auch Nutzstrahlung genannt) zwischen 30 und 250 nm. Das Strahlformungs- und Beleuchtungssystem 102 und das Projektionssystem 104 können - wie bereits mit Bezug zu Fig. 1a beschrieben - in einem Vakuumgehäuse angeordnet und/oder von einem Maschinenraum mit entsprechenden Steuereinrichtungen umgeben sein. In der Fig. 1b ist lediglich ein Vakuumgehäuse 101, welches das Projektionssystem 104, die Photomaske 120 sowie eine Vorrichtung 1 umfasst, gezeigt. Die Vorrichtung 1 ist - wie ebenfalls im Bezug zu Fig. 1a beschrieben - zur elektrischen Signalübertragung zu dem Projektionssystem 104 eingerichtet. Verschiedene Ausführungsbeispiele der Vorrichtung 1 sind in den Fig. 2 - Fig. 6 gezeigt.

Die DUV-Lithographieanlage 100B weist eine DUV-Lichtquelle 106B auf. Als DUV-Lichtquelle 106B kann beispielsweise ein ArF-Excimerlaser vorgesehen sein, welcher Strahlung 108B im DUV-Bereich bei beispielsweise 193 nm emittiert.

Das in Fig. 1B dargestellte Strahlformungs- und Beleuchtungssystem 102 leitet die DUV-Strahlung 108B auf eine Photomaske 120. Die Photomaske 120 ist als transmissives optisches Element ausgebildet und kann außerhalb der Systeme 102, 104 angeordnet sein. Die Photomaske 120 weist Strukturen auf, welche mittels des Projektionssystems 104 verkleinert auf einen Wafer 124 oder dergleichen abgebildet werden. Dabei ist der Wafer 124 in der Bildebene des Projektionssystems 104 angeordnet.

Das Projektionssystem 104 weist mehrere Linsen 128 und/oder Spiegel 130 zur Abbildung der Photomaske 120 auf den Wafer 124 auf. Dabei können einzelne Linsen 128 und/oder Spiegel 130 des Projektionssystems 104 symmetrisch zur optischen Achse 126 des Projektionssystems 104 angeordnet sein. Es sollte beachtet werden, dass die Anzahl der Linsen und Spiegel der DUV-Lithographieanlage 100B nicht auf die dargestellte Anzahl beschränkt ist. Es können auch mehr oder weniger Linsen und/oder Spiegel vorgesehen sein. Des Weiteren sind die Spiegel in der Regel an ihrer Vorderseite zur Strahlformung gekrümmt.

Ein Luftspalt zwischen der letzten Linse 128 und dem Wafer 124 kann durch ein flüssiges Medium 132 ersetzt sein, welches einen Brechungsindex > 1 aufweist. Das flüssige Medium kann beispielsweise hochreines Wasser sein. Ein solcher Aufbau wird auch als Immersionslithographie bezeichnet und weist eine erhöhte photolithographische Auflösung auf.

Die in den Fig. 2 - Fig. 6 gezeigten Ausführungsbeispiele der Vorrichtung 1 eignen sich jeweils beispielsweise zur Informations-, Leistungs- oder Datenübertragung in einer der in den Fig. 1a und Fig. 1b gezeigten Lithographieanlagen 100A, 100B.

Fig. 2 zeigt einen Querschnitt einer ersten Ausführungsbeispiels der Vorrichtung 1 zur Übertragung von elektrischen Signalen zwischen einer ersten Struktur 10 und einer zweiten Struktur 20. In dem ersten Ausführungsbeispiel ist der Hohlkörper 40 als ein einstückiger Hohlkörper 40 ausgebildet, der an der ersten Struktur 10 angeordnet und leitend mit dieser verbunden ist. Er weist einen Rand 41 auf, der eine Öffnung zu der zweiten Struktur 20 hin bildet. Zwischen dem Rand 41 und der zweiten Struktur 20 bildet sich ein Spalt 43 aus. Der Hohlkörper 40 umschließt ein Volumen 42, welches in der Fig. 2 gepunktet hinterlegt ist und welches ein im Wesentlichen störfeldfreies Volumen 42 darstellt. An der ersten Struktur 10 ist ein erstes Schnittstellenelement 11 angeordnet, welches über einen elektrischen Leiter 30, der als ein flexibles Kabel 30 ausgebildet ist und der in dem Volumen 42 verläuft, mit einem an der zweiten Struktur 20 angeordneten zweiten Schnittstellenelement 21 verbunden ist. Aufgrund des Spalts 43 können sich die zweite Struktur 20 und der Hohlkörper 40 unabhängig voneinander bewegen, sofern eine Bewegungsamplitude nicht größer als der Spalt 43 ist. Die erste Struktur 10 und die zweite Struktur 20 als auch der Hohlkörper 40 sind in dem Ausführungsbeispiel auf ein Massepotential gelegt (nicht dargestellt).

Fig. 3 zeigt einen Querschnitt eines zweiten Ausführungsbeispiels der Vorrichtung 1 zur Übertragung von elektrischen Signalen zwischen einer ersten Struktur 10 und einer zweiten Struktur 20. In diesem Ausführungsbeispiel umfasst der Hohlkörper 40 zwei Teilkörper 44 und 45, die sich in einem Überdeckungsabschnitt 46 überschneiden. Der Spalt 43 wird in diesem Überdeckungsabschnitt 46 ausgebildet. Der erste Teilkörper 44 ist an der ersten Struktur 10 angeordnet und leitend mit dieser verbunden. Der zweite Teilkörper 45 ist an der zweiten Struktur 20 angeordnet und leitend mit dieser verbunden. Die weiteren Merkmale entsprechen jenen des ersten Ausführungsbeispiels der Fig. 2.

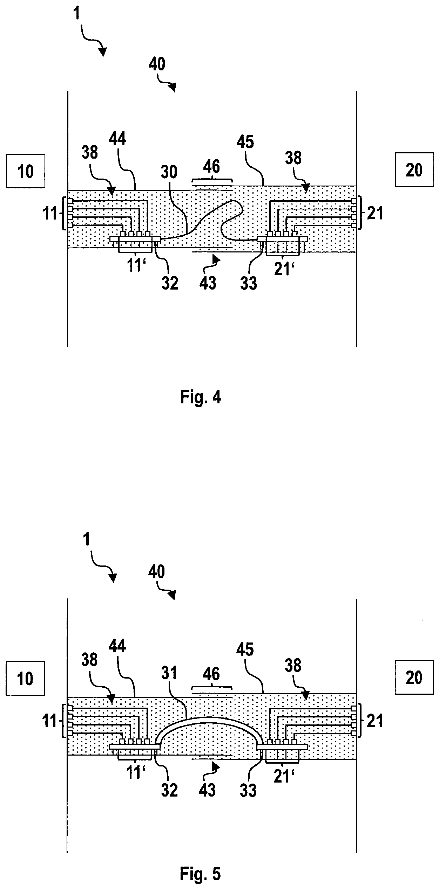

Fig. 4 zeigt einen Querschnitt eines dritten Ausführungsbeispiels der Vorrichtung 1 zur Übertragung von elektrischen Signalen zwischen einer ersten Struktur 10 und einer zweiten Struktur 20. In diesem Ausführungsbeispiel ist der Hohlkörper 40, wie in dem zweiten Ausführungsbeispiel der Fig. 3, zweiteilig aufgebaut. Darüber hinaus sind hier Leiterplatten 32, 33 vorgesehen, wobei jeweils eine Leiterplatte 32, 33 in einem der Teilkörper 44, 45 angeordnet ist. Das erste Schnittstellenelement 11 umfasst vier einzelne Schnittstellen, die mittels starrer Leitungen 38 mit entsprechenden Kontakten 11' auf der ersten Leiterplatte 32 verbunden sind. Auch das Schnittstellenelement 21 umfasst vier einzelne Schnittstellen, die mittels starrer Leitungen 38 mit entsprechenden Kontakten 21' auf der zweiten Leiterplatte 33 verbunden sind. Die erste Leiterplatte 32 ist mit der zweiten Leiterplatte 33 über ein flexibles Kabel 30 verbunden, welches die benötigte Anzahl an Einzeladern aufweist. Die weiteren Merkmale dieses Ausführungsbeispiels entsprechen jenen des Ausführungsbeispiels der Fig. 3.

Fig. 5 zeigt einen Querschnitt eines vierten Ausführungsbeispiels der Vorrichtung 1 zur Übertragung von elektrischen Signalen zwischen einer ersten Struktur 10 und einer zweiten Struktur 20. Das gezeigte vierte Ausführungsbeispiel unterscheidet sich von dem dritten Ausführungsbeispiel der Fig. 4 dadurch, dass eine flexible Leiterplatte 31 anstelle des flexiblen Kabels 30 die beiden in den Teilkörpern 44, 45 angeordneten Leiterplatten 32 und 33 verbindet. Die weiteren Merkmale entsprechen jenen des dritten Ausführungsbeispiels.

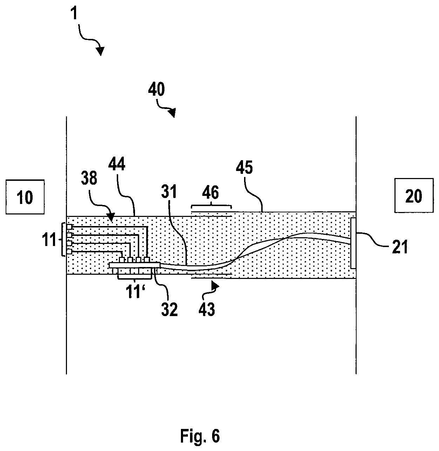

Fig. 6 zeigt einen Querschnitt eines fünften Ausführungsbeispiels der Vorrichtung 1 zur Übertragung von elektrischen Signalen zwischen einer ersten Struktur 10 und einer zweiten Struktur 20. Dieses Ausführungsbeispiel unterscheidet sich von dem vierten Ausführungsbeispiel der Fig. 5 dadurch, dass das zweite Schnittstellenelement 21 als eine Leiterplatte 21 ausgebildet ist, welche über eine flexible Leiterplatte 31 mit der ersten Leiterplatte 32 in dem ersten Teilkörper 44 verbunden ist. Man kann auch sagen, dass die zweite Leiterplatte 33 (siehe Fig. 5) an der zweiten Struktur 20 angeordnet ist. Die weiteren Merkmale entsprechen jenen der dritten oder auch der vierten Ausführungsform.

Es ist über die Darstellung hinaus möglich, dass alternativ oder zusätzlich das erste Schnittstellenelement 11 als eine Leiterplatte ausgebildet ist.

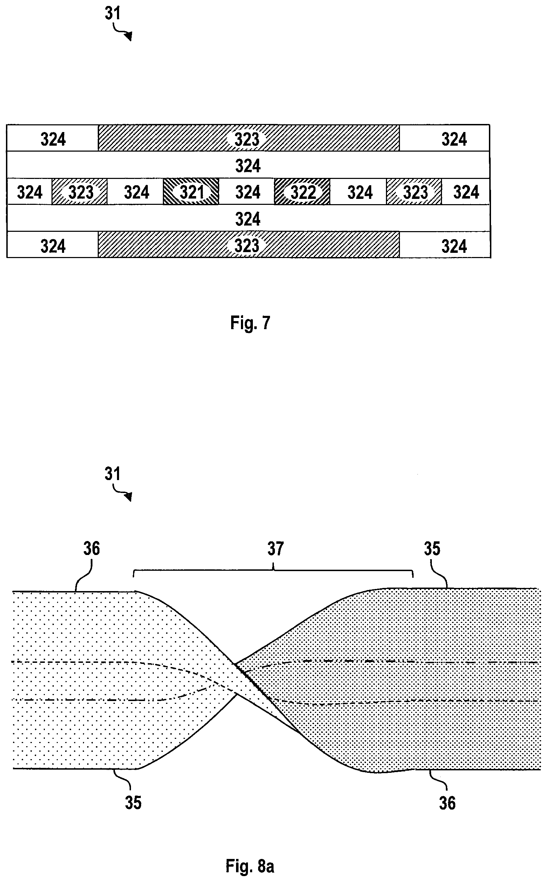

Fig. 7 zeigt einen Querschnitt eines Ausführungsbeispiels einer flexiblen Leiterplatte 31. Die Darstellung ist derart, dass die flexible Leiterplatte 31 in die Papierebene hinein- bzw. aus der Papierebene heraustritt. Die dargestellte Leiterplatte 31 weist insgesamt fünf übereinander angeordnete Schichten auf. Dabei sind in einer ersten, dritten und fünften Schicht jeweils Leiterbahnen 321, 322, 323 vorgesehen. Eine zweite und vierte Schicht dient als Substrat für die flexible Leiterplatte 31, welches diese mechanisch stabilisiert, die Schichten zusammenhält sowie übereinander angeordnete Leiterbahnen 321, 322, 323 gegeneinander isoliert. Das Substratmaterial 324 ist beispielsweise Polyimid. Insbesondere in der dritten Schicht sind mehrere Leiterbahnen 321, 322, 323 nebeneinander angeordnet, welche durch das dazwischen angeordnete Substratmaterial 324 gegeneinander isoliert sind. Die Leiterbahnen 321 und 322 dienen in diesem Ausführungsbeispiel der Signalübertragung, wobei eine differenzielle Signalübertragung bereitgestellt werden kann. In der ersten und der fünften Schicht sind jeweils breite Leiterbahnen 323 vorgesehen. Die Leiterbahnen 323 sind auf ein Massepotential gesetzt. Die gezeigte Anordnung weist somit abschirmende Eigenschaften für die mittig angeordneten Leiterbahnen 321 und 322 auf. Eine gemäß diesem Ausführungsbeispiel aufgebaute flexible Leiterplatte 31 eignet sich beispielsweise zur Verwendung in der Vorrichtung 1 gemäß einem der genannten Ausführungsbeispiele der Vorrichtung 1.

Fig. 8a zeigt schematisch einen Ausschnitt einer in einem Abschnitt zu einer Helixform verdrehten flexiblen Leiterplatte 31. Die flexible Leiterplatte 31 erstreckt sich in dieser Darstellung von links nach rechts. Ferner sind in der Darstellung eine Oberseite und eine Unterseite der Leiterplatte 31 durch unterschiedliche Schraffuren kenntlich gemacht. Die flexible Leiterplatte 31 weist einen ersten Randabschnitt 35 und einen gegenüberliegenden zweiten Randabschnitt 36 auf. Von links kommend ist der zweite Randabschnitt 36 ein oberer Randabschnitt. In dieser Orientierung weist die Oberseite der Leiterplatte 31 aus der Papierebene heraus. Entlang des Verlaufs der Leiterplatte 31 nach rechts weist die Leiterplatte 31 einen Abschnitt 37 auf, in dem die flexible Leiterplatte 31 verdreht ist. Die Randabschnitte 35, 36 bilden in diesem Abschnitt 37 eine Helixform aus. Der Drehgrad in diesem Ausführungsbeispiel beträgt beispielhaft 180°. Dies führt dazu, dass weiter rechts, nach dem Abschnitt 37, die Randabschnitte vertauscht sind, so dass nun der erste Randabschnitt 35 ein oberer Randabschnitt ist. Ferner weist in dieser Orientierung nun die Unterseite der Leiterplatte 31 aus der Papierebene heraus. In der Fig. 8a sind ferner zwei nicht bezeichnete Hilfslinien eingezeichnet, die den Orientierungswechsel verdeutlichen. Die dargestellte Ausführungsform weist eine Flexibilität in der Papierebene auf, welche ohne einen verdrehten Abschnitt 37 nicht oder nur sehr gering vorhanden wäre.

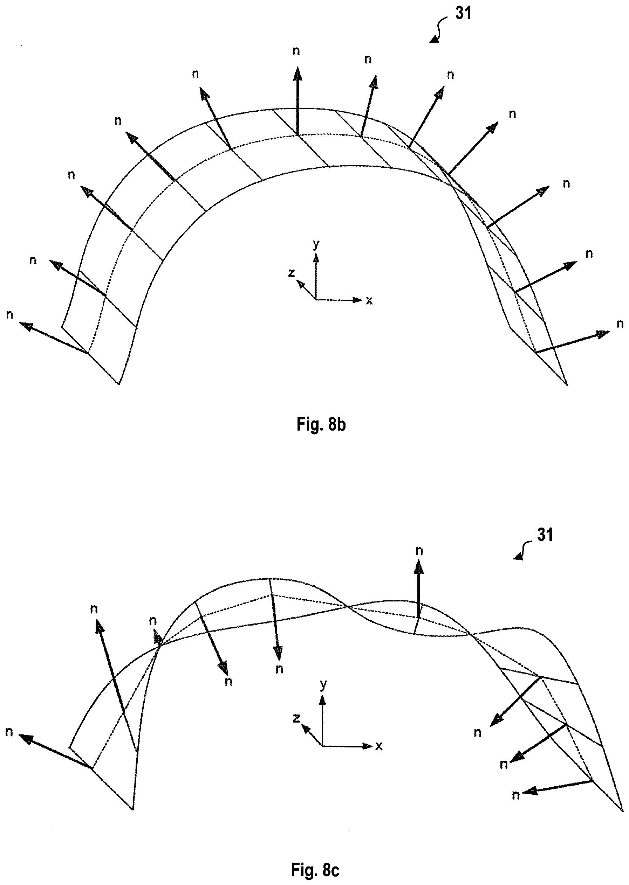

Fig. 8b zeigt eine schematische Ansicht einer Ausführungsform eines bestimmten Abschnitts einer flexiblen Leiterplatte 31. Die flexible Leiterplatte 31 der Fig. 8b erstreckt sich in dieser Darstellung von links nach rechts. Der bestimmte Abschnitt der flexiblen Leiterplatte 31 der Fig. 8b ist gebogen. Mit anderen Worten bildet die Längsachse dieses Abschnitts der flexiblen Leiterplatte 31 keine Strecke, sondern einen Bogen aus. Die Normalenvektoren n auf der Längsachse der flexiblen Leiterplatte 31 der Fig. 8b haben unterschiedliche Richtungen und liegen in einer Ebene.

Fig. 8c zeigt eine schematische Ansicht einer weiteren Ausführungsform eines bestimmten Abschnitts einer flexiblen Leiterplatte 31. Der bestimmte Abschnitt der flexiblen Leiterplatte 31 gemäß Fig. 8c ist verdreht. Verdreht bedeutet hier, dass die Normalenvektoren n auf die Längsachse des bestimmten Abschnitts der flexiblen Leiterplatte 31 in diesem bestimmten Abschnitt unterschiedliche Richtungen haben und eine jede Gruppe von drei der Normalenvektoren n zueinander linear unabhängig sind. Letztere Eigenschaft kann auch damit beschrieben werden, dass eine jede Gruppe von drei der Normalenvektoren n in Fig. 8c stets einen dreidimensionalen Raum aufspannen.

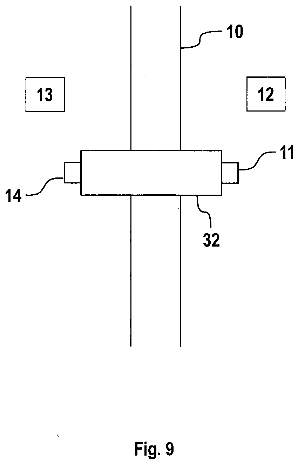

Fig. 9 zeigt schematisch ein Ausführungsbeispiel einer Leiterplatte 32, die als Vakuumdurchführung verwendet wird. Die Leiterplatte 32 ist hierzu in die erste Struktur 10 eingearbeitet. Auf einer ersten Seite 12 der ersten Struktur 10 herrscht ein erster Druck und auf einer zweiten Seite 13 der ersten Struktur 10 herrscht ein gegenüber dem ersten Druck erhöhter, zweiter Druck. Das erste Schnittstellenelement 11 ist auf der Leiterplatte 32 auf der ersten Seite 12 ausgebildet und ein weiteres Schnittstellenelement 14 ist auf der Leiterplatte 32 auf zweiten Seite 13 ausgebildet. Die gezeigte Anordnung lässt sich analog auch auf die zweite Struktur 20 (siehe eine der Fig. 1 - 6) übertragen.

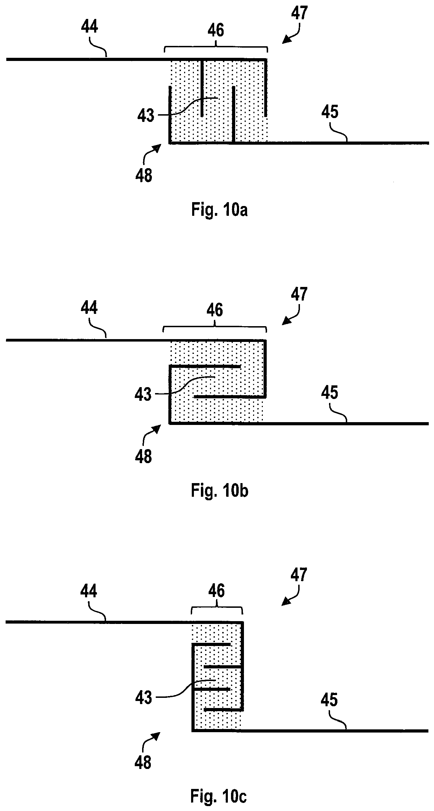

Fig. 10a - Fig. 10c zeigen verschiedene Ausführungsbeispiele von Randstrukturen 47, 48 zur Ausbildung eines Spalts 43. Die gezeigten Ausführungsbeispiele basieren auf einem zweiteilig ausgebildeten Hohlkörper 40, beispielsweise gemäß dem zweiten, dem dritten, dem vierten oder dem fünften Ausführungsbeispiel der Vorrichtung 1. Die Randstruktur 47 ist dabei dem Teilkörper 44 zugeordnet und die Randstruktur 48 ist dem Teilkörper 45 zugeordnet. Die Randstruktur 47 bildet beispielsweise ein Stück und die Randstruktur 48 bildet ein Gegenstück. Die beiden Randstrukturen 47, 48 überlappen sich in dem Überdeckungsbereich 46. Der Spalt 43, der sich zwischen den Randstrukturen 47,48 ausbildet, verläuft in den Fig. 10a - 10c jeweils schlangenförmig. Man kann auch von einer zick-zack Form sprechen oder von einer mäandrierenden Form. Eine solche Spaltform kann eine Abschirmung verbessern. Ferner kann eine solche Spaltform eine verbesserte Eindringbarriere oder Diffusionsbarriere darstellen.

Neben der Darstellung mit zwei Teilkörpern 44, 45 ist es möglich, dass einer der Randabschnitte 47, 48 direkt an einer der Strukturen 10, 20 angeordnet ist. Dann kann der Hohlkörper 40 auch einstückig ausgebildet sein, beispielsweise wie es in der ersten Ausführungsform der Vorrichtung 1 gezeigt ist.

Obwohl die vorliegende Erfindung anhand von Ausführungsbeispielen beschrieben wurde, ist sie vielfältig modifizierbar. Die Erfindung wird durch die Ansprüche definiert.

### BEZUGSZEICHENLISTE

- 1: Vorrichtung
- 10: erste Struktur
- 11: erstes Schnittstellenelement
- 11': Kontakt
- 12: erste Seite der ersten Struktur
- 13: zweite Seite der ersten Struktur
- 14: weiteres Schnittstellenelement
- 20: zweite Struktur
- 21: zweites Schnittstellenelement
- 21': Kontakt
- 30: elektrischer Leiter
- 31: flexible Leiterplatte
- 32: erste Leiterplatte
- 33: zweite Leiterplatte
- 35: erster Randabschnitt
- 36: zweiter Randabschnitt
- 37: Abschnitt
- 38: Leitungen
- 40: Hohlkörper
- 41: Rand
- 42: elektromagnetisch abgeschirmtes Volumen
- 43: Spalt
- 44: erster Teilkörper
- 45: zweiter Teilkörper
- 46: Überdeckungsabschnitt
- 47: Randstruktur
- 48: Randstruktur
- 100: Lithographieanlage
- 100A: EUV-Lithographieanlage
- 100B: DUV-Lithographieanlage
- 101: Vakuumgehäuse
- 102: Strahlformungs- und Beleuchtungssystem
- 104: Projektionssystem
- 106A: EUV-Lichtquelle
- 106B: DUV-Lichtquelle
- 108A: EUV-Strahlung
- 108B: DUV-Strahlung
- 110 - 118: Spiegel
- 120: Photomaske
- 122: Spiegel
- 124: Wafer
- 126: optische Achse
- 128: Linse
- 130: Spiegel
- 132: Immersionsflüssigkeit
- 321: Leiterbahn
- 322: Leiterbahn
- 323: Leiterbahn
- 324: Substratmaterial

- M1-M6: Spiegel
- n: Normalenvektor

## Patentansprüche

1. Lithographieanlage (100) mit einer Vorrichtung (1) zur Übertragung von elektrischen Signalen zwischen einem ersten Schnittstellenelement (11), das an einer ersten Struktur (10) der Lithographieanlage (100) angeordnet ist, und einem zweiten Schnittstellenelement (21), das an einer zweiten Struktur (20) der Lithographieanlage (100) angeordnet ist, wobei ein elektrischer Leiter (30) das erste Schnittstellenelement (11) und das zweite Schnittstellenelement (21) verbindet und ein den elektrischen Leiter (30) zumindest abschnittsweise umgebender Hohlkörper (40) zur elektromagnetischen Abschirmung des elektrischen Leiters (30) vorgesehen ist, **dadurch gekennzeichnet, dass** ein Spalt (43) in dem Hohlkörper (40) oder zwischen dem Hohlkörper (40) und einer der Strukturen (10, 20) vorgesehen ist, welcher eine Relativbewegung der ersten Struktur (10) und der zweiten Struktur (20) zur mechanischen Entkopplung der ersten Struktur (10) von der zweiten Struktur (20) zulässt.

2. Lithographieanlage gemäß Anspruch 1, wobei die Vorrichtung (1) in einem Vakuumgehäuse (101) angeordnet ist.

3. Lithographieanlage gemäß Anspruch 1 oder 2, wobei der elektrische Leiter (30) zumindest abschnittsweise als eine flexible Leiterplatte (31) ausgebildet ist.

4. Lithographieanlage gemäß einem der Ansprüche 1 - 3, wobei der Hohlkörper (40) an der ersten Struktur (10) angeordnet und leitend mit dieser verbunden ist, wobei der Hohlkörper (40) eine der zweiten Struktur (20) zugewandte Öffnung mit einem Rand (41) aufweist, wobei der Rand (41) mit der zweiten Struktur (20) den Spalt (43) ausbildet.

5. Lithographieanlage gemäß einem der Ansprüche 1 - 3, wobei der Hohlkörper (40) zwei Teilkörper (44, 45) umfasst, wobei ein erster Teilkörper (44) an der ersten Struktur (10) angeordnet und leitend mit dieser verbunden ist und ein zweiter Teilkörper (45) an der zweiten Struktur (20) angeordnet und leitend mit dieser verbunden ist, wobei der Spalt (43) in einem Überdeckungsabschnitt (46) zwischen den beiden Teilkörpern (44, 45) in dem Hohlkörper (40) ausgebildet ist.

6. Lithographieanlage gemäß Anspruch 5, wobei in dem ersten Teilkörper (44) eine erste Leiterplatte (32), die mit dem ersten Schnittstellenelement (11) elektrisch verbunden ist, und in dem zweiten Teilkörper (45) eine zweite Leiterplatte (33), die mit dem zweiten Schnittstellenelement (21) elektrisch verbunden ist, vorgesehen sind, wobei die erste Leiterplatte (32) mit der zweiten Leiterplatte (33) über den elektrischen Leiter (30) verbunden ist.

7. Lithographieanlage gemäß Anspruch 6, wobei die erste Leiterplatte (32) mit der zweiten Leiterplatte (33) über die flexible Leiterplatte (31) verbunden ist.

8. Lithographieanlage gemäß einem der Ansprüche 3 - 7, wobei die flexible Leiterplatte (31) einen ersten Randabschnitt (35) und einen dem ersten Randabschnitt (35) gegenüberliegenden zweiten Randabschnitt (36) aufweist, wobei die flexible Leiterplatte (31) entlang ihres Verlaufs derart verdreht ist, dass sie einen Abschnitt (37) aufweist, in dem der erste Randabschnitt (35) und der zweite Randabschnitt (36) eine Helixform bilden.

9. Lithographieanlage gemäß einem der Ansprüche 3 - 7, wobei zumindest ein bestimmter Abschnitt der flexiblen Leiterplatte (31) gebogen und/oder verdreht ist.

10. Lithographieanlage gemäß einem der Ansprüche 1 - 9, wobei die Vorrichtung (1) in einer Niederdruck-Atmosphäre mit erhöhtem Wasserstoffgehalt angeordnet ist und der Spalt (43) derart eingerichtet ist, dass ein Eindringen von Wasserstoff in den Hohlkörper (40) unterdrückt wird.

11. Lithographieanlage gemäß einem der Ansprüche 1 - 10, wobei auf einer ersten Seite (12) der ersten Struktur (10) ein erster Druck herrscht und auf einer zweiten Seite (13) der ersten Struktur (10) ein gegenüber dem ersten Druck erhöhter, zweiter Druck herrscht, wobei das erste Schnittstellenelement (11) auf einer Leiterplatte (32) auf der ersten Seite (12) ausgebildet ist und die Leiterplatte (32) ein weiteres Schnittstellenelement (14) auf der zweiten Seite (13) aufweist.

12. Lithographieanlage gemäß einem der Ansprüche 1 - 11, wobei der Spalt (43) derart ausgebildet ist, dass er eine Relativbewegung zwischen der ersten Struktur (10) und der zweiten Struktur (20) von höchstens 200 µm, bevorzugt von höchstens 100 µm, weiter bevorzugt von höchstens 10 µm, zulässt.

13. Lithographieanlage gemäß einem der Ansprüche 1 - 12, wobei der elektrische Leiter (30) eine mechanische Kopplungsstärke von höchstens 200 N/m, bevorzugt höchstens 100 N/m, weiter bevorzugt höchstens 20 N/m und noch weiter bevorzugt höchstens 7 N/m aufweist.

14. Lithographieanlage gemäß einem der Ansprüche 1 - 13, wobei der elektrische Leiter (30) als Teil eines das erste Schnittstellenelement (11) und das zweite Schnittstellenelement (21) verbindendes Kabel ausgebildet ist, welches eine Anzahl von einfach abgeschirmten Aderpaaren und/oder eine Anzahl von Spannungsversorgungsleitungen in einem Kabelmantel umfasst.

15. Lithographieanlage gemäß einem der Ansprüche 5 - 14, wobei der der Spalt (43) durch eine in dem Bereich des Überdeckungsabschnitts (46) erste Randstruktur (47) des ersten Teilkörpers (44) und eine zu der ersten Randstruktur (46) korrespondierende zweite Randstruktur (48) des zweiten Teilkörpers (45) ausgebildet ist, wobei die erste Randstruktur (47) und die zweite Randstruktur (48) ineinandergreifende Strukturen sind.

## Claims

1. Lithography apparatus (100) comprising a device (1) for transmitting electrical signals between a first interface element (11), which is arranged at a first structure (10) of the lithography apparatus (100), and a second interface element (21), which is arranged at a second structure (20) of the lithography apparatus (100), wherein an electrical conductor (30) connects the first interface element (11) and the second interface element (21) and provision is made of a hollow body (40) surrounding the electrical conductor (30) at least in sections and serving for the electromagnetic shielding of the electrical conductor (30), **characterized in that** a gap (43) is provided in the hollow body (40) or between the hollow body (40) and one of the structures (10, 20), which gap permits a relative movement of the first structure (10) and the second structure (20) for the mechanical decoupling of the first structure (10) from the second structure (20).

2. Lithography apparatus according to Claim 1, wherein the device (1) is arranged in a vacuum housing (101).

3. Lithography apparatus according to Claim 1 or 2, wherein the electrical conductor (30) is formed at least in sections as a flexible printed circuit board (31).

4. Lithography apparatus according to any of Claims 1-3, wherein the hollow body (40) is arranged at the first structure (10) and is conductively connected thereto, wherein the hollow body (40) has an opening facing the second structure (20) and having an edge (41), wherein the edge (41) together with the second structure (20) forms the gap (43).

5. Lithography apparatus according to any of Claims 1-3, wherein the hollow body (40) comprises two partial bodies (44, 45), wherein a first partial body (44) is arranged at the first structure (10) and is conductively connected thereto and a second partial body (45) is arranged at the second structure (20) and is conductively connected thereto, wherein the gap (43) is formed in an overlap section (46) between the two partial bodies (44, 45) in the hollow body (40).

6. Lithography apparatus according to Claim 5, wherein a first printed circuit board (32), which is electrically connected to the first interface element (11), is provided in the first partial body (44) and a second printed circuit board (33), which is electrically connected to the second interface element (21), is provided in the second partial body (45), wherein the first printed circuit board (32) is connected to the second printed circuit board (33) via the electrical conductor (30).

7. Lithography apparatus according to Claim 6, wherein the first printed circuit board (32) is connected to the second printed circuit board (33) via the flexible printed circuit board (31).

8. Lithography apparatus according to any of Claims 3-7, wherein the flexible printed circuit board (31) has a first edge section (35) and a second edge section (36) opposite the first edge section (35), wherein the flexible printed circuit board (31) is rotated along its course in such a way that it has a section (37) in which the first edge section (35) and the second edge section (36) form a helix shape.

9. Lithography apparatus according to any of Claims 3-7, wherein at least one specific section of the flexible printed circuit board (31) is bent and/or rotated.

10. Lithography apparatus according to any of Claims 1-9, wherein the device (1) is arranged in a low-pressure atmosphere with elevated hydrogen content and the gap (43) is configured in such a way that penetration of hydrogen into the hollow body (40) is suppressed.

11. Lithography apparatus according to any of Claims 1-10, wherein a first pressure prevails on a first side (12) of the first structure (10) and a second pressure, which is increased by comparison with the first pressure, prevails on a second side (13) of the first structure (10), wherein the first interface element (11) is formed on a printed circuit board (32) on the first side (12) and the printed circuit board (32) has a further interface element (14) on the second side (13).

12. Lithography apparatus according to any of Claims 1-11, wherein the gap (43) is formed in such a way that it permits a relative movement between the first structure (10) and the second structure (20) of at most 200 µm, preferably of at most 100 µm, more preferably of at most 10 µm.

13. Lithography apparatus according to any of Claims 1-12, wherein the electrical conductor (30) has a mechanical coupling strength of at most 200 N/m, preferably at most 100 N/m, more preferably at most 20 N/m and even more preferably at most 7 N/m.

14. Lithography apparatus according to any of Claims 1-13, wherein the electrical conductor (30) is formed as part of a cable which connects the first interface element (11) and the second interface element (21) and which comprises a number of singly shielded core pairs and/or a number of voltage supply lines in a cable sheath.

15. Lithography apparatus according to any of Claims 5-14, wherein the gap (43) is formed by a first edge structure (47) of the first partial body (44) in the region of the overlap section (46) and a second edge structure (48) of the second partial body (45), said second edge structure (48) corresponding to the first edge structure (46), wherein the first edge structure (47) and the second edge structure (48) are intermeshing structures.

## Revendications

1. Système de lithographie (100) comprenant un dispositif (1) de transmission de signaux électriques entre un premier élément d'interface (11), qui est disposé sur une première structure (10) du système de lithographie (100), et un deuxième élément d'interface (21) qui est disposé sur une deuxième structure (20) du système de lithographie (100), un conducteur électrique (30) reliant le premier élément d'interface (11) et le deuxième élément d'interface (21) et un corps creux (40) qui entoure le conducteur électrique (30) au moins par portions étant prévu pour réaliser le blindage électromagnétique du conducteur électrique (30), **caractérisé en ce qu'**un espace (43) est ménagé dans le corps creux (40) ou entre le corps creux (40) et l'une des structures (10, 20), lequel espace permet un mouvement relatif de la première structure (10) et de la deuxième structure (20) afin de découpler mécaniquement la première structure (10) de la deuxième structure (20).

2. Système de lithographie selon la revendication 1, le dispositif (1) étant disposé dans un boîtier sous vide (101).

3. Système de lithographie selon la revendication 1 ou 2, le conducteur électrique (30) étant conçu au moins par portions sous la forme d'une carte de circuit imprimé flexible (31).

4. Système de lithographie selon l'une des revendications 1 à 3, le corps creux (40) étant disposé sur la première structure (10) et étant relié à celle-ci de manière conductrice, le corps creux (40) comportant une ouverture dirigée vers la deuxième structure (20) et pourvue d'un bord (41), le bord (41) formant avec la deuxième structure (20) l'espace (43).

5. Système de lithographie selon l'une des revendications 1 à 3, le corps creux (40) comprenant deux parties de corps (44, 45), une première partie de corps (44) étant disposée sur la première structure (10) et étant reliée à celle-ci de manière conductrice, et une deuxième partie de corps (45) étant disposée sur la deuxième structure (20) et étant relié à celle-ci de manière conductrice, l'espace (43) étant ménagé dans le corps creux (40) dans une portion de recouvrement (46) située entre les deux parties de corps (44, 45).

6. Système de lithographie selon la revendication 5, une première carte de circuit imprimé (32), qui est reliée électriquement au premier élément d'interface (11), étant prévue dans la première partie de corps (44) et une deuxième carte de circuit imprimé (33), qui est reliée électriquement au deuxième élément d'interface (21), étant prévue dans la deuxième partie de corps (45), la première carte de circuit imprimé (32) étant reliée à la deuxième carte de circuit imprimé (33) par le biais du conducteur électrique (30).

7. Système de lithographie selon la revendication 6, la première carte de circuit (32) étant reliée à la deuxième carte de circuit (33) par le biais de la carte de circuit flexible (31).

8. Système de lithographie selon l'une des revendications 3 à 7, la carte de circuit imprimé flexible (31) comportant une première portion de bord (35) et une deuxième portion de bord (36) opposée à la première portion de bord (35), la carte de circuit imprimé flexible (31) ayant un profil tordu de manière à comporter une portion (37) dans laquelle la première portion de bord (35) et la deuxième portion de bord (36) forment une hélice.

9. Système de lithographie selon l'une des revendications 3 à 7, au moins une portion déterminée de la carte de circuit flexible (31) étant courbée et/ou tordue.

10. Système de lithographie selon l'une des revendications 1 à 9, le dispositif (1) étant disposé dans une atmosphère à basse pression ayant une teneur en hydrogène accrue et l'espace (43) étant disposé de manière à supprimer la pénétration d'hydrogène dans le corps creux (40).

11. Système de lithographie selon l'une des revendications 1 à 10, une première pression régnant sur un premier côté (12) de la première structure (10) et une deuxième pression supérieure à la première pression régnant sur un deuxième côté (13) de la première structure (10), le premier élément d'interface (11) étant formé sur une carte de circuit imprimé (32) sur le premier côté (12) et la carte de circuit imprimé (32) comportant un autre élément d'interface (14) sur le deuxième côté (13).

12. Système de lithographie selon l'une des revendications 1 à 11, l'espace (43) étant conçu de manière à permettre un mouvement relatif entre la première structure (10) et la deuxième structure (20) d'au plus 200 µm, de préférence d'au plus 100 µm, plus préférablement d'au plus 10 µm.

13. Système de lithographie selon l'une des revendications 1 à 12, le conducteur électrique (30) présentant une force d'accouplement mécanique d'au plus 200 N/m, de préférence d'au plus 100 N/m, plus préférablement d'au plus 20 N/m et encore plus préférablement d'au plus 7 N/m.

14. Système de lithographie selon l'une des revendications 1 à 13, le conducteur électrique (30) étant conçu comme une partie d'un câble qui relie le premier élément d'interface (11) et le deuxième élément d'interface (21) et qui comprend un certain nombre de paires de fils à simple blindage et/ou un certain nombre de lignes d'alimentations en tension dans une gaine de câble.

15. Système de lithographie selon l'une des revendications 5 à 14, l'espace (43) étant formé par une première structure de bord (47) de la première partie de corps (44) qui est située dans la région de la portion de recouvrement (46) et une deuxième structure de bord (48) de la deuxième partie de corps (45) qui correspond à la première structure de bord (46), la première structure de bord (47) et la deuxième structure de bord (48) étant des structures qui s'engagent l'une dans l'autre.
